# DEMANDE DE BREVET EUROPEEN

(11) **EP 0 991 154 A1**
(43) Date de publication de la demande: **05.04.2000**
(21) Numéro de dépôt: 99402397.6
(22) Date de dépôt: 30.09.1999
(51) Int. Cl.: H01S 5/50

(54) **Amplificateur optique en semi-conducteur**

(30) Priorité: 02.10.1998 FR 9812385
(71) Demandeur: ALCATEL, 75008 Paris (FR)
(72) Inventeur: Goldstein, Léon, 94230 Cachan (FR); Emery, Jean-Yves, 94230 Cachan (FR); Gaborit, Fabienne, 94230 Cachan (FR)
(74) Mandataire: Ballot, Paul

(57) **Abrégé**

L'invention concerne un amplificateur optique en semi-conducteur insensible à la polarisation de la lumière. La couche active (20) de cet amplificateur comprend une alternance de sous-couches massives alternativement contraintes en tension (21) et en compression (22) et ayant la même largeur de bande interdite. Les sous-couches contraintes en tension (21) privilégient la propagation du mode TM de polarisation de la lumière et les sous-couches en compression (22) privilégient la propagation du mode TE de polarisation de la lumière. De plus, les épaisseurs des sous-couches ont des valeurs procurant des gains G(TE) et G(TM) égaux pour la couche active.

## Description

La présente invention se rapporte à un amplificateur optique en semi-conducteur insensible à la polarisation de la lumière et présentant de bonnes performances. Il présente notamment un gain élevé, un rapport signal à bruit élevé et un facteur de confinement élevé.

Les amplificateurs optiques en semi-conducteur, insensibles à la polarisation de la lumière, sont actuellement fabriqués selon différentes méthodes. Parmi ces méthodes, deux ont été particulièrement utilisées ces derniers temps car leurs résultats théoriques semblaient prometteurs.

Une première méthode consiste à faire croître sur un substrat en matériau III-V, de type InP par exemple, une couche active de section rectangulaire. Le matériau de cette couche active est en outre choisi de telle sorte qu'il subisse une légère contrainte en tension. Pour cela, son paramètre de maille a est légèrement inférieur au paramètre de maille du substrat.

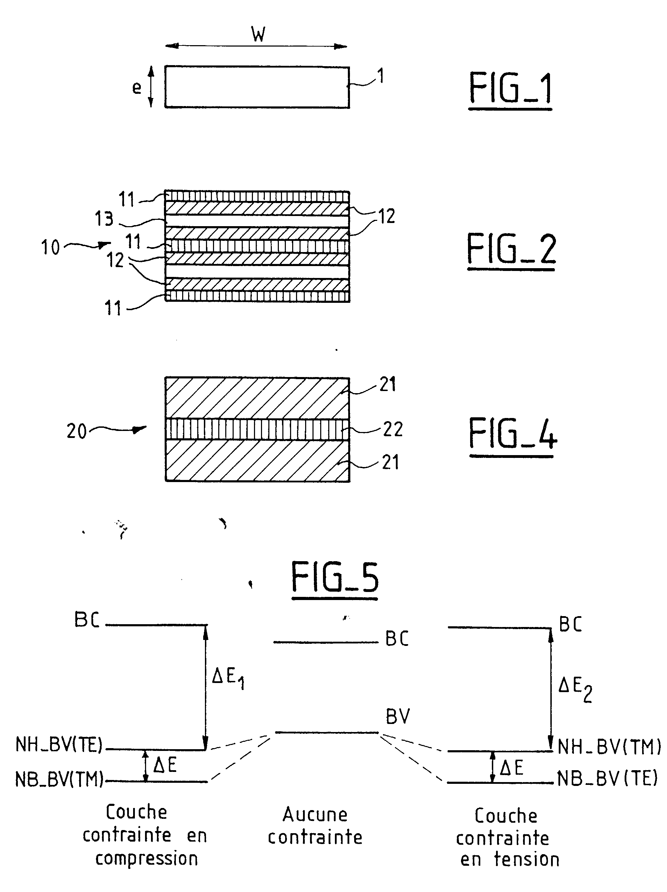

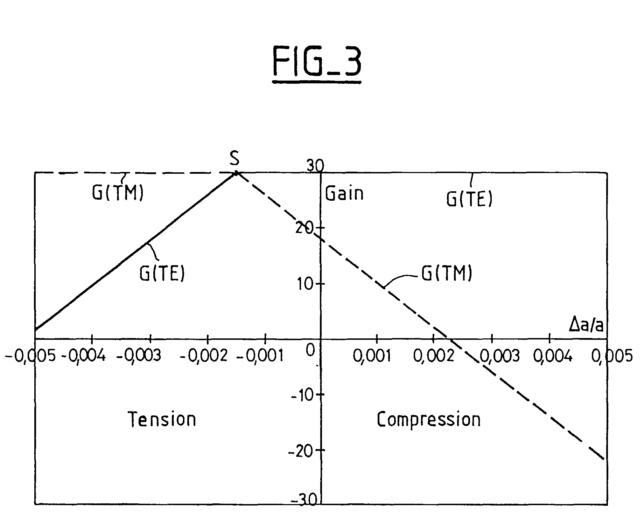

La figure 1 schématise cette couche active 1 de section rectangulaire. La figure 3, quant à elle, représente la variation du gain G (en dB décibels) de la couche active 1 de l'amplificateur, selon les différents modes TE (en traits pleins) et TM (en traits pointillés) de polarisation de la lumière, en fonction des contraintes Δa/a. Le gain G de la couche active est proportionnel au produit g x Γ où g représente le gain propre au matériau de constitution de la couche active, sous contrainte, et Γ représente le facteur de confinement. Dans ce premier mode de réalisation, le matériau de constitution de la couche active subit une légère tension. Typiquement, la tension Δa/a appliquée est de l'ordre de -1,6.10⁻³.

Cependant, une légère variation de la contrainte en tension Δa/a entraîne une forte variation du gain G de la couche active. Sur la courbe de la figure 3, on constate que si l'on souhaite avoir une variation du gain inférieure au dB, il faut que la variation de la contrainte Δa/a soit inférieure à 1.10⁻⁴. Or, une telle précision sur la contrainte en tension à appliquer dans le matériau de la couche active 1 n'est pas facile à contrôler. De plus, étant donné que la contrainte appliquée dans la couche active 1 est une contrainte Δa/a en tension, le gain G(TM) de cette couche active, selon le mode TM de polarisation de la lumière, est supérieur au gain G(TE), selon le mode TE de polarisation de la lumière. Il est donc très difficile de maîtriser les variations du gain G de la couche active de l'amplificateur. Par conséquent, il apparaît très difficile d'équilibrer les gains G(TE) et G(TM) de la couche active par le contrôle de la contrainte en tension.

D'autre part, l'épaisseur de la section de couche active 1 joue également un rôle important sur les facteurs de confinement Γ puisqu'elle permet de contrôler le rapport Γ(TE)/Γ(TM). Dans l'exemple de la figure 1, cette épaisseur e est par exemple de 300 nm tandis que la largeur w de la section est par exemple de 1000 nm. En fait, la forme rectangulaire de la section de couche active permet d'obtenir un facteur de confinement Γ plus élevé selon le mode TE que selon le mode TM.

A partir des relations G(TM) = g(TM) x Γ(TM) et G(TE) = g(TE) x Γ(TE), et du fait que la faible contrainte en tension engendre un gain, dans le matériau de la couche active, tel que g(TM)> g(TE) et que la forme de la couche active entraine un facteur de confinement tel que Γ(TE)> Γ(TM) ; il suffit d'ajuster la forme de la section, et en particulier son épaisseur, ainsi que la contrainte en tension dans le matériau, pour faire varier les paramètres g(TE), g(TM), Γ(TE) et Γ(TM) de manière à obtenir une égalité entre les gains G(TE) et G(TM) de l'amplificateur. Une telle égalité entre les gains G(TE) et G(TM) de l'amplificateur permet de rendre l'amplificateur insensible à la polarisation de la lumière.

Cependant l'épaisseur de la couche active est également très difficile à contrôler avec précision. En général on ne peut pas contrôler une épaisseur absolue à mieux de 2%. Cette marge d'erreur de 2% entraîne donc également une marge d'erreur, qui ne peut pas être contrôlée, sur les facteurs de confinement Γ(TE) et Γ(TM).

Les variations des gains dans le matériau de la couche active g(TE) et g(TM), ainsi que des facteurs de confinement Γ(TE) et Γ(TM) étant difficiles à maîtriser, il est par conséquent très difficile d'équilibrer les gains G (TE) et G (TM) pour rendre l'amplificateur insensible à la polarisation de la lumière. Cette première méthode ne permet donc pas, dans la pratique, d'obtenir des résultats satisfaisants, de manière reproductible.

Une deuxième méthode consiste à faire croître, sur un substrat en matériau III-V, de type InP par exemple, une couche active présentant une structure à puits quantiques. Une section de cette couche active 10 est schématisée sur la figure 2. La structure quantique comprend une succession de couches très mince à puits quantiques 11, 12, contraintes alternativement en compression 11 et en tension 12, et de couches barrières 13 constituées par un matériau à large bande d'énergie interdite et faible indice de réfraction.

Dans ce cas, les contraintes en tension et en compression sont élevées. Les contraintes en tension Δa/a sont en effet inférieures à -6.10⁻³ et les contraintes en compression Δa/a sont supérieures à +6.10⁻³. Dans ce cas, les couches contraintes en tension présentent un gain propre à leur matériau de constitution g(TE) négligeable par rapport à leur gain g(TM). Inversement, les couches contraintes en compression présentent un gain propre à leur matériau de constitution g(TM) négligeable par rapport à leur gain g(TE). La couche active de l'amplificateur réalisé selon cette deuxième méthode présente donc une alternance de couches très minces à puits quantiques qui sont purement TE ou purement TM, c'est à dire que les couches à puits quantiques ne laissent se propager alternativement qu'un seul des modes TE ou TM de polarisation de la lumière.

Le gain global G de la couche active de l'amplificateur étant proportionnel au produit g x Γ, il suffit ensuite de faire varier les facteurs de confinement Γ(TE) et Γ(TM) des différentes couches pour équilibrer les gains G(TE) et G(TM) en vue de rendre l'amplificateur insensible à la polarisation de la lumière. Pour cela, il faut ajuster le nombre de puits quantiques dans les couches, c'est à dire qu'il faut contrôler le rapport des épaisseurs des différentes couches. Le contrôle d'un rapport d'épaisseurs peut être réalisé de manière plus précise qu'un contrôle d'épaisseur absolue. Il semble donc que les facteurs de confinement puissent être ajustés plus facilement que dans le cas de la méthode précédemment décrite.

Cependant, dans ce deuxième mode de réalisation connu, les épaisseurs des différentes couches sont très minces, elles sont en général comprises entre 6 et 12nm. Cette faible épaisseur des couches entraîne l'obtention de faibles facteurs de confinement Γ(TE) et Γ(TM). Or, il est important, pour avoir un bon rendement, que les amplificateurs optiques en semiconducteurs aient des facteurs de confinement élevés. Pour augmenter les valeurs de ces facteurs de confinement Γ(TE) et Γ(TM), il faut multiplier le nombre de puits quantiques et de barrières 13. Cependant une telle multiplication entraîne d'autres problèmes, notamment des problèmes de nature électrique, car le courant d'injection devient non uniforme entre les puits.

De plus, pour former la structure quantique de la couche active 10, il est nécessaire de faire croître trois types de matériau différents : un premier type pour former les couches à puits quantiques contraintes en tension 12, un deuxième type pour former les couches à puits quantiques contraintes en compression 11, et un troisième type pour former les couches barrières 13. Or, la croissance de trois types de matériau différents, pour former une succession de couches d'épaisseurs très fines, est difficile à contrôler avec précision et complexe à mettre en oeuvre. Par conséquent, les amplificateurs fabriqués selon cette deuxième méthode ne présentent pas toujours, dans la pratique, les résultats escomptés.

La présente invention permet de pallier les inconvénients précités puisqu'elle propose un amplificateur optique en semi-conducteur insensible à la polarisation de la lumière et présentant un facteur de confinement élevé quelque soit le mode TE ou TM de polarisation de la lumière. Pour cela, la couche active de l'amplificateur selon l'invention comporte une structure verticale non quantique comprenant une succession de sous-couches dont le gain g est purement TE ou purement TM et dont les épaisseurs ont des valeurs procurant un équilibre des gains G(TE) et G(TM) de la couche active.

L'invention se rapporte plus particulièrement à un amplificateur optique en semi-conducteur comprenant une couche active déposée sur un substrat en matériau III-V, caractérisé en ce que ladite couche active comprend une succession de sous-couches massives contraintes alternativement en tension et en compression, lesdites sous-couches ayant la même largeur de bande d'énergie interdite ; en ce que les sous-couches contraintes en tension privilégient la propagation du mode TM de polarisation de la lumière, et les sous-couches contraintes en compression privilégient la propagation du mode TE de polarisation de la lumière ; et en ce que les épaisseurs des sous-couches ont des valeurs procurant des gains G(TE) et G(TM) égaux pour la couche active.

Selon une autre caractéristique de l'invention, les épaisseurs des sous-couches sont supérieures à 30 nm et inférieures à 100 nm.

Selon une autre caractéristique de l'invention, l'épaisseur des sous-couchés contraintes en tension est supérieure à l'épaisseur des sous-couches contraintes en compression.

Selon encore une autre caractéristique de l'invention, les sous-couches sont réalisées dans un matériau quaternaire dont la composition est différente selon que lesdites sous-couches sont contraintes en tension ou en compression.

Selon encore une autre caractéristique le matériau quaternaire des sous-couches est du InGaAsP ou du AlGaInAs.

Selon encore une autre caractéristique de l'invention, les contraintes en tension sont comprises entre -3.10⁻³ et -1.10⁻² et les contraintes en compression sont comprises entre +3.10⁻³ et +1.10⁻².

D'autres particularités et avantages de l'invention apparaîtront à la lecture de la description donnée à titre d'exemple illustratif et faite en référence aux figures annexées qui représentent :
- la figure 1, déjà décrite, la section de la couche active d'un amplificateur optique selon un premier mode de réalisation de l'art antérieur,
- la figure 2, déjà décrite, la section de la couche active d'un amplificateur optique selon un deuxième mode de réalisation de l'art antérieur,
- la figure 3, des courbes représentant la variation du gain global G(TE) et G(TM) de la couche active de l'amplificateur, selon les différents modes de polarisation de la lumière, en fonction des contraintes en tension ou en compression appliquées sur l'ensemble des sous-couches de constitution de la couché active,
- la figure 4 un schéma de la section de la couche active d'un amplificateur optique selon l'invention,
- la figure 5, un schéma d'un diagramme d'énergies correspondant à des sous-couches de constitution de la couche active d'un amplificateur optique selon l'invention, contraintes respectivement en compression et en tension.

La structure de la couche active 20 d'un amplificateur optique en semi-conducteur selon l'invention est schématisée, par sa section, sur la figure 4. Cette couche active 20 est déposée sur un substrat en matériau III-V, de type InP par exemple, non représenté sur la figure 4. Cette structure n'est pas une structure à multi-puits quantiques. La couche active 20 comprend une succession de sous-couches massives 21, 22 qui sont contraintes alternativement en tension 21 et en compression 22.

Les valeurs des contraintes Δa/a en tension et en compression sont choisies moyennes mais suffisantes pour que les sous-couches soient considérées comme étant alternativement purement TE et purement TM, c'est à dire qu'elles privilégient la propagation alternativement d'un seul mode TE ou TM de polarisation de la lumière. De plus, les sous-couches 21 et 22 sont déposées sur de grandes épaisseurs, typiquement supérieures ou égale à 30 nm. Du fait de ces grandes épaisseurs, il est préférable de choisir des contraintes moyennes en tension et en compression. En effet, des couches aussi épaisses ne supportent pas des contraintes Δa/a trop élevées qui risquent d'entraîner la formation de dislocations dégradant la qualité cristalline des couches. Typiquement, les contraintes en tension sont donc de préférence choisies entre-3.10⁻³ et -1.10⁻² et les contraintes en compression sont de préférence choisies entre +3.10⁻³ et +1.10⁻².

Dans ce cas, les sous-couches en tension 21 sont considérés comme étant purement TM car le gain g(TE) propre à leur matériau de constitution est négligeable par rapport au gain g(TM) . Inversement, les sous-couches en compression 22 sont considérées comme étant purement TE car le gain g(TM) propre à leur matériau de constitution est négligeable par rapport au gain g(TE). La couche active est par conséquent constituée d'une alternance de sous-couches considérées purement TE et de sous-couches considérées purement TM.

Etant donné que les couches épaisses n'acceptent pas de fortes contraintes Δa/a au risque d'être dégradées par l'apparition de dislocations, il existe une épaisseur critique à ne pas dépasser. Cette épaisseur critique est de 100 nm. Par conséquent, les sous-couches successives 21, 22 composant la couche active 20 de l'amplificateur selon l'invention présentent chacune une épaisseur comprise entre 30 et 100 nm.

De plus, étant donné que la structure de la couche active n'est pas une structure à multi-puits quantiques, la présence de sous-couches barrières, qui présentent l'inconvénient de ne pas amplifier l'onde lumineuse les traversant, n'est pas nécessaire. L'absence de sous-couches barrières permet donc d'obtenir des sous-couches contraintes en tension 21 et en compression 22 plus confinées, si bien que l'amplificateur selon l'invention présente des facteurs de confinement Γ(TE) et Γ(TM) plus élevés que dans l'amplificateur de l'art antérieur tel que précédemment décrit.

Le matériau utilisé pour les sous-couches successives est un matériau quaternaire dont la composition varie selon que les sous-couches sont contraintes en tension ou en compression, ladite composition agissant sur le paramètre de maille du matériau. Le matériau quaternaire utilisé est par exemple du InGaAsP ou du AlGaInAs. De plus, le matériau quaternaire, bien que possédant une composition différente selon le type de contraintes auxquelles sont soumises les sous-couches, présente une longueur d'onde équivalente toujours identique et égale, par exemple, à 1,55 µm.

Les gains propres au matériau de constitution des sous-couches contraintes alternativement en tension et en compression étant respectivement purement TM (gTM)) et purement TE (g(TE)), ils sont identiques (tel qu'illustré sur la figure 3). Cependant, si les sous-couches contraintes en tension 21 sont de même épaisseur que les sous-couches contraintes en compression 22, les facteurs de confinement Γ(TE) et Γ(TM) ne sont pas équilibrés et on observe notamment que Γ(TM) est inférieur à Γ(TE). Par conséquent, dans ce cas les gains G(TE) et G(TM) de l'amplificateur ne sont pas non plus équilibrés et on obtient G(TE) = g(TE) x Γ(TE) > G(TM) = g(TM) x Γ(TM). Pour compenser ce déséquilibre entre les facteurs de confinement, et donc entre les gains de la couche active de l'amplificateur, il faut contrôler les épaisseurs des sous-couches 21 et 22.

Ces épaisseurs sont contrôlées de manière précise, par le contrôle du rapport des épaisseurs entre les sous-couches contraintes en tension 21 et les sous-couches contraintes en compression 22. Ce contrôle du rapport des épaisseurs permet de faire varier les facteurs de confinement Γ(TE) et Γ(TM) et par conséquent d'équilibrer les gains G(TE) et G(TM) de la couche active 20 de l'amplificateur selon l'invention.

L'épaisseur des sous-couches contraintes en tension 21 doit donc être supérieure à l'épaisseur des sous-couches contraintes en compression 22, et elle est choisie de telle sorte que la tension globale de la couche active soit égale à -1,6.10⁻³. Cette valeur de la tension globale permet en effet d'équilibrer les facteurs de confinement, ainsi que les gains G(TE) et G(TM) de la couche active et d'obtenir un amplificateur insensible à la polarisation de la lumière. Cet équilibre entre les gains G(TE) et G(TM) est référencé au point S sur les courbes de la figure 3.

Ainsi, pour équilibrer les gains G(TE) et G(TM) de la couche active 20, l'homme du métier choisira les épaisseurs des différentes sous-couches 21 et 22 de telle sorte qu'elles soient comprises dans le domaine de 30 à 100nm, et en contrôlant leur rapport pour obtenir une tension globale dans la couche active égale à -1,6.10⁻³.

L'amplificateur optique en semi-conducteur obtenu est donc insensible à la polarisation de la lumière, il présente un gain élevé, un facteur de confinement élevé et un bas prix de revient. Grâce à la structure périodique de la couche active et aux épaisseurs élevées des sous-couches, le rapport des épaisseurs est relativement aisé à contrôler. De plus, les contraintes Δa/a appliquées dans les sous-couches étant moyennes, leur contrôle n'a pas besoin d'être précis car les sous-couches restent purement TE ou purement TM même si il se produit une légère variation de ces contraintes.

D'autre part, la structure de la couche active de l'amplificateur selon l'invention étant périodique, contrairement aux structures antérieures, il est beaucoup plus facile de la contrôler par les techniques de caractérisation aux rayons X.

La figure 5 représente la structure de bande des sous-couches contraintes en compression et en tension. Lorsque l'on introduit une contrainte dans un matériau, on lève la dégénérescence de la bande de valence BV du matériau. La bande de valence possède donc un niveau haut NH-BV et un niveau bas NB-BV.

Dans le cas des sous-couches contraintes en compression, le niveau fondamental (niveau haut de la bande de valence NH-BV) correspond au mode de polarisation TE de la lumière et l'autre niveau (NB-BV) correspond au mode de polarisation TM de la lumière. Lorsque la différence d'énergie ΔE entre ces deux niveaux est suffisante, c'est à dire lorsque cette différence d'énergie ΔE est typiquement supérieure à 60mev, le gain se fait uniquement sur le niveau fondamental, c'est à dire que le gain propre au matériau de la couche contrainte en compression sera TE. Dans ce cas, en effet, le niveau bas (NB-BV) n'est pratiquement pas occupé par les trous, si bien que le gain g(TM) selon le mode de polarisation TM est négligeable devant le gain g(TE). Par conséquent, lorsque la différence d'énergie entre les deux niveaux TE et TM de la bande de valence d'une sous-couche en compression est suffisante, c'est à dire supérieure à 60 mev, on peut considérer que le gain g propre à la sous-couche est purement g(TE). Ce diagramme d'énergies confirme bien les observations décrites précédemment ainsi que les courbes de la figure 3.

Dans le cas des sous-couches contraintes en tension, c'est l'inverse, c'est à dire que le niveau fondamental (niveau haut de la bande de valence NH-BV) correspond au mode de polarisation TM et l'autre niveau (NB-BV) correspond au mode de polarisation TE de la lumière. Par conséquent, lorsque la différence d'énergie entre ces deux niveaux est suffisante, typiquement supérieure à 60mev, le niveau fondamental (NH-BV), correspondant au mode TM, est occupé par les trous, alors que l'autre niveau (NB-BV), correspondant au mode TE, ne l'est pratiquement pas. On peut donc considérer, dans ce cas, que le gain propre au matériau de la couche contrainte en tension est purement TM, g(TE) étant négligeable devant g(TM).

Par ailleurs, la largeur de la bande d'énergie interdite ΔE₁, entre la bande de conduction BC et la bande de valence BV, des sous-couches contraintes en compression doit être identique à la largeur de la bande d'énergie interdite ΔE₂, entre la bande de conduction BC et la bande de valence BV, des sous-couches contraintes en tension.

## Revendications

1. Amplificateur optique en semi-conducteur comprenant une couche active (20) déposée sur un substrat en matériau III-V, caractérisé en ce que ladite couche active (20) comprend une succession de sous-couches massives contraintes alternativement en tension (21) et en compression (22), lesdites sous-couches ayant la même largeur de bande d'énergie interdite,
en ce que les sous-couches contraintes en tension (21) privilégient la propagation du mode TM de polarisation de la lumière, et les sous-couches contraintes en compression (22) privilégient la propagation du mode TE de polarisation de la lumière,
et en ce que les épaisseurs des sous-couches ont des valeurs procurant des gains G(TE) et G(TM) égaux pour la couche active (20).

2. Amplificateur selon la revendication 1, caractérisé en ce que les épaisseurs des sous-couches (21, 22) sont supérieures à 30 nm et inférieures à 100 nm.

3. Amplificateur selon l'une des revendications 1 à 2, caractérisé en ce que l'épaisseur des sous-couches contraintes en tension (21) est supérieure à l'épaisseur des sous-couches contraintes en compression (22).

4. Amplificateur selon l'une des revendications 1 à 3, caractérisé en ce que les sous-couches (21, 22) sont réalisées dans un matériau quaternaire dont la composition est différente selon que lesdites sous-couches sont contraintes en tension ou en compression.

5. Amplificateur selon la revendication 4, caractérisé en ce que le matériau quaternaire est du InGaAsP ou du AlGaInAs.

6. Amplificateur selon l'une des revendications 1 à 5, caractérisé en ce que les contraintes en tension sont comprises entre -3.10⁻³ et -1.10⁻² et les contraintes en compression sont comprises entre +3.10⁻³ et +1.10⁻².
